**Europäisches Patentamt**

(19) **European Patent Office**

**Office européen des brevets**

(11) Veröffentlichungsnummer: **0 176 082**

**A2**

(12) # EUROPÄISCHE PATENTANMELDUNG

(21) Anmeldenummer: **85112111.1**

(22) Anmeldetag: **24.09.85**

(51) Int. Cl.⁴: **H 01 H 13/70**

(30) Priorität: **28.09.84 DE 3435836**

(43) Veröffentlichungstag der Anmeldung:
**02.04.86 Patentblatt 86/14**

(84) Benannte Vertragsstaaten:
**AT BE CH FR GB IT LI LU NL SE**

(71) Anmelder: **PREH, Elektrofeinmechanische Werke Jakob Preh Nachf. GmbH & Co.
Postfach 1740 Schweinfurter Strasse 5
D-8740 Bad Neustadt/Saale(DE)**

(72) Erfinder: **Oelsch, Jürgen, Dipl.-Ing.
Saaleblick 23
D-8741 Hohenroth(DE)**

(54) **Anschlusseinrichtung einer Schaltungsfolie.**

(57) Bei einer Anschlußeinrichtung einer Schaltungsfolie sind auf eine flexible Trägerfolie 1 Bahnen als Leiter oder Widerstände aufgebracht. Um an eine Anschlußleiste 17, an der ein erster Schaltungsteil liegt, einen zweiten Schaltungsteil kreuzungsfrei anzuschließen und eine einfache Herstellung zu erlauben, ist die Folie 1 längs einer Knicklinie 18 geknickt, die quer zu den Bahnen 9,10, 11, 15 verläuft. An den gegeneinander geknickten Folienteilen 20, 21 liegen die Bahnen 2 bis 15 außen und die Knicklinie 18 steckt in der Anschlußleiste 17.

Fig. 1

EP 0 176 082 A2

J P-18/84

Preh-Elektrofeinmechanische Werke,
Jakob Preh Nachf. GmbH & Co., 8740 Bad Neustadt / Saale

Anschlußeinrichtung einer Schaltungsfolie

Die Erfindung betrifft eine Anschlußeinrichtung einer
Schaltungsfolie mit einer flexiblen Trägerfolie, auf
die Bahnen als Leiter oder Widerstände aufgebracht sind,
wobei Anschlußstellen an einer Anschlußleiste liegen.

In der Literaturstelle "ELEKTRONIK, 1979, S. 39, 40
ist eine Tastatur-Matrix beschrieben. Alle Spaltenleiter
sind an Anschlüsse gelegt und über Widerstände an eine
Versorgungsspannung angeschlossen. Dadurch ist erreicht,
daß an den Spaltenleitern bei nicht betätigten Tasten
die Versorgungsspannung anliegt. Diese Schaltung läßt
sich auf verschiedenen Wegen realisieren. Beispielsweise können die Widerstände auf einer separaten Trägerplatte angeordnet und mit der Anschlußleiste verbunden sein. Dies wäre aufwendig, da die Schaltung der Tastenmatrix oder die Schaltung der Widerstände separat hergestellt werden und die beiden Schaltungsteile mit der gemeinsamen Anschlußleiste verbunden werden müßten.

Die Widerstandsschaltung auf dem Träger der Tastenmatrix zu integrieren wäre ungünstig, da dabei Kreuzungsstellen entstünden.

Aufgabe der Erfindung ist es, eine Einrichtung der eingangs genannten Art anzugeben, die einfach herzustellen ist und bei der an einer an einem ersten Schaltungsteil liegenden Anschlußleiste ein zweiter Schaltungsteil liegt, der an den ersten Schaltungsteil kreuzungsfrei angeschlossen ist.

Erfindungsgemäß ist obige Aufgabe bei einer Einrichtung der eingangs genannten Art dadurch gelöst, daß die Folie längs einer Knicklinie geknickt ist, die quer zu den Bahnen verläuft und auf der die Bahnen im Abstand des Rasters der Anschlußleiste liegen, daß an den gegeneinander geknickten Folienteilen die Bahnen außen liegen und daß die Knicklinie in der Anschlußleiste steckt.

Es lassen sich beide Schaltungsteile einfach auf die gleiche Seite kreuzungsfrei aufbringen. Durch das Knicken der Folie werden Anschlußstellen für das Einstecken in die Anschlußleiste zugänglich, die zwischen den Schaltungsteilen liegen.

In Ausgestaltung der Erfindung verläuft die gerade
Knicklinie in einem Bereich, in dem sich die Bahnen in
einem Winkel von 90° zur Knicklinie erstrecken.

Vorzugsweise übergreift die Anschlußleiste beide Folienteile. Dadurch ist vermieden, daß etwaige Fehlstellen
der Bahnen im Knick zu einem unsicheren Kontakt führen.

In bevorzugter Ausgestaltung der Erfindung schneidet
die Knicklinie erste Widerstandsbahnen und der auf dem
einen Folienteil liegende Teil der ersten Widerstandsbahn ist etwa ebenso lang wie der auf dem anderen Folienteil liegende Teil der ersten Widerstandsbahn. Dadurch
ist erreicht, daß die Anschlußleiste Widerstandsbahnen
und nicht Leiterbahnen kontaktiert. Dies ist günstig,
weil die Widerstandsbahnen widerstandsfähiger gegen die
im Betrieb auftretenden Bedingungen sind.

In Weiterbildung der Erfindung bestehen die ersten
Widerstandsbahnen und auf dem einen Folienteil anschliessende zweite Widerstandsbahnen aus dem gleichen Widerstandsmaterial. Dadurch sind mit einem einzigen Druckvorgang alle Widerstandsbahnen herzustellen. Es kann
dann die erste Widerstandsbahn und die zweite Widerstandsbahn eine durchgehende Widerstandsbahn bilden.
Leiter zwischen den Widerstandsbahnen entfallen dann.
Zum Aufbau der eingangs genannten Schaltung, bei der
an den Anschlußstellen über die zweiten Widerstands-

- 4 -

bahnen eine Versorgungsspannung liegt, sind in Ausgestaltung der Erfindung die der Anschlußleiste abgewandten Pole der zweiten Widerstandsbahn mit einer
gemeinsamen Leiterbahn verbunden, die zur Anschlußleiste führt.

Weitere vorteilhafte Ausgestaltungen der Erfindung ergeben sich aus der folgenden Beschreibung eines Ausführungsbeispiels und den Unteransprüchen. In der Zeichnung
zeigen:

Figur 1   eine Anschlußeinrichtung einer Schaltungsfolie,
          perspektivisch und

Figur 2   die ungeknickte, bedruckte Folie.

Eine flexible Trägerfolie 1 ist mit Leiterbahnen 2 bis 8
bedruckt. Zwischen den Leiterbahnen 2 und 5 bzw. 3 und 6
bzw. 4 und 7 liegen erste Widerstandsbahnen 9, 10 und 11.
Zwischen der Leiterbahn 8 und den Leiterbahnen 5 bzw. 6
bzw. 7 sind zweite Widerstandsbahnen 12, 13 und 14
gedruckt. Die Leiterbahn 8 ist zu einer Widerstandsbahn 15 geführt. Die Widerstandsbahnen 9 bis 15 sind in
einem einzigen Druckvorgang aus der gleichen Widerstandspaste gedruckt.

Die Widerstandsbahnen 9, 10, 11 und 15 liegen parallel
zueinander und weisen den Abstand von Anschlußstiften 16

- 5 -

einer Anschlußleiste 17 auf. Die Widerstandsbahnen 2, 3
und 4 führen zu nicht näher dargestellten Schaltstellen
einer Tastatur in Matrixanordnung.

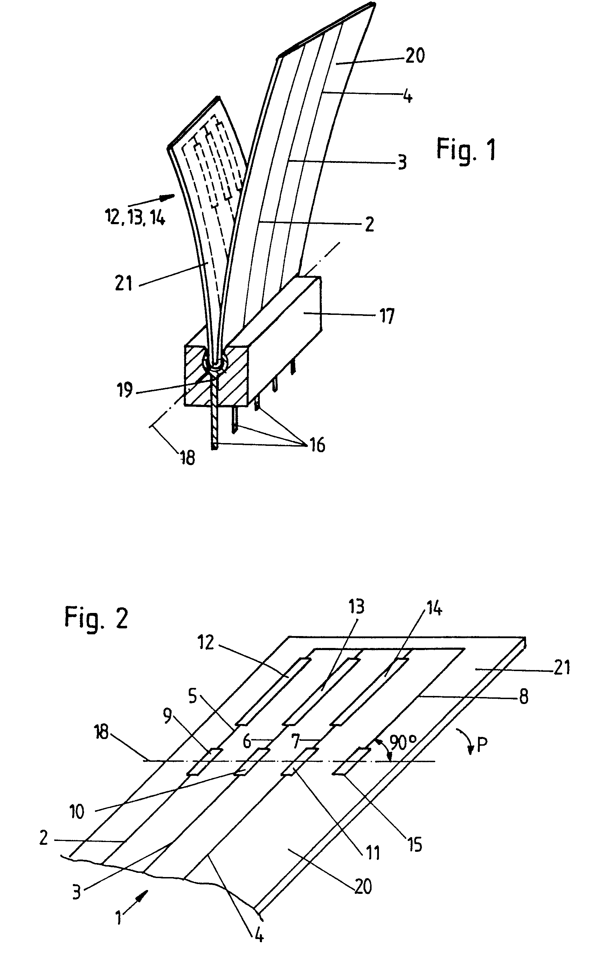

Die Trägerfolie 1 ist längs einer Knicklinie 18 um 180°
in Richtung des Pfeiles P (vgl. Figur 2) geknickt (vgl.
Figur 1). Die Knicklinie 18 erstreckt sich mittig durch
die Widerstandsbahnen 9, 10 und 11 und verläuft im
90°-Winkel zur Längserstreckung der Widerstandsbahnen.

Die Anschlußstifte 16 sind mit in der Anschlußleiste 17
gelagerten Klammern 19 versehen, die beidseitig der
Knicklinie 18 an den Widerstandsbahnen 9, 10, 11 und 15
anliegen. Die Klammern 19 übergreifen dabei die Knicklinie 18.

Durch den Knick der Folie 1 sind zwei Folienteile 20
und 21 entstanden, deren Schaltungen jeweils an den
Widerstandsbahnen 9 bzw. 10 bzw. 11 bzw. 15 elektrisch
über die Anschlußstifte 16 anschließbar sind. Ersichtlich ergeben sich dabei keine Kreuzungsstellen der
Leiterbahnen oder der Widerstandsbahnen.

Dadurch, daß an den Folienteilen 20 und 21 die Leiterbahnen 2 bis 8 und die Widerstandsbahnen 9 bis 15 außen,
also auf den einander abgewandten Seiten der Folienteile 20 und 21 liegen, ist ein einfaches Kontaktieren
durch Einstecken der geknickten Folie 1 in die Anschlußleiste 17 möglich.

A n s p r ü c h e

1.    Anschlußeinrichtung einer Schaltungsfolie mit
einer flexiblen Trägerfolie,auf die Bahnen als Leiter
oder Widerstände aufgebracht sind, wobei Anschlußstellen an einer Anschlußleiste liegen, dadurch gekennzeichnet, daß die Folie (1) längs einer Knicklinie (18)
geknickt ist, die quer zu den Bahnen (9, 10, 11, 15) verläuft und auf der die Bahnen (9, 10, 11; 15) im Abstand des
Rasters der Anschlußleiste (16, 17) liegen, daß an den
gegeneinander geknickten Folienteilen (20, 21) die
Bahnen (2 bis 15) außen liegen und daß die Knicklinie (18) in der Anschlußleiste (17) steckt.

2.    Einrichtung nach Anspruch 1, dadurch gekennzeichnet, daß die gerade Knicklinie (18) in einem Bereich
verläuft, in dem sich die Bahnen (9, 10, 11, 15) im
Winkel von 90° zur Knicklinie (18) erstrecken.

3.    Einrichtung nach Anspruch 1 oder 2, dadurch gekennzeichnet, daß die Anschlußleiste (17) beide Folienteile (20, 21) übergreift.

4.    Einrichtung nach einem der vorhergehenden Ansprüche,
dadurch gekennzeichnet, daß die Knicklinie (18) erste
Widerstandsbahnen (9, 10, 11) schneidet und der auf dem
einen Folienteil (20) liegende Teil der ersten Widerstandsbahn etwa ebenso lang ist wie der auf dem zweiten
Folienteil (21) liegende Teil der Widerstandsbahnen
(9, 10, 11).

5.  Einrichtung nach einem der vorhergehenden Ansprüche, dadurch gekennzeichnet, daß an quer zu der Knicklinie (18) verlaufenden ersten Widerstandsbahnen (9, 10, 11) zweite Widerstandsbahnen (12, 13, 14) auf dem einen Folienteil (21) anschließen und daß die ersten Widerstandsbahnen (9, 10, 11) und die zweiten Widerstandsbahnen (12, 13, 14) gemeinsam aus dem gleichen Widerstandsmaterial bestehen.

6.  Einrichtung nach Anspruch 5, dadurch gekennzeichnet, daß die erste Widerstandsbahn (9, 10, 11) und die zweite Widerstandsbahn (12, 13, 14) eine durchgehende Widerstandsbahn bilden.

7.  Einrichtung nach Anspruch 6, dadurch gekennzeichnet, daß der auf dem einen Folienteil (20) liegende Teil der durchgehenden Widerstandsbahn kürzer ist als der auf dem anderen Folienteil (21) liegende Teil der Widerstandsbahn.

8.  Einrichtung nach einem der vorhergehenden Ansprüche, dadurch gekennzeichnet, daß die der Anschlußleiste (17) abgewandten Pole der zweiten Widerstandsbahn (12, 13, 14) mit einer gemeinsamen Leiterbahn (8) verbunden sind, die zur Anschlußleiste (17) führt.

9.  Einrichtung nach Anspruch 8, dadurch gekennzeichnet, daß in der Leiterbahn (8) eine weitere Widerstandsbahn liegt.

10.    Einrichtung nach Anspruch 8 oder 9, dadurch gekennzeichnet, daß die Leiterbahn (8) an einer Widerstandsbahn (15) endet, die neben den ersten Widerstandsbahnen (9, 10, 11) auf der Knicklinie (18) liegt.

0176082

Fig. 1

Fig. 2

18/84 -